# EUROPEAN PATENT APPLICATION

(11) **EP 1 272 018 A2**
(43) Date of publication of application: **02.01.2003**
(21) Application number: 02011952.5
(22) Date of filing: 29.05.2002
(51) Int. Cl.: H05K 3/34

(54) **Method of mounting electronic parts with Sn-Zn solder free of Pb**

(30) Priority: 01.06.2001 JP 2001166827
(71) Applicant: NEC CORPORATION, Tokyo (JP)
(72) Inventor: Sakai, Hiroshi, c/o NEC Corporation, Tokyo (JP); Suzuki, Motoji, c/o NEC Corporation, Tokyo (JP); Igarashi, Makoto, Nagaoka-shi, Niigata (JP); Tanaka, Akihiro, Nakakubiki-gun, Niigata (JP)
(74) Representative: Betten & Resch

(57) **Abstract**

There is disclosed a method of mounting electronic parts with Sn - Zn solder which is Pb-free solder without a reduction in the bonding strength. A printed circuit board for mounting electronic parts with Pb-free solder comprises a printed circuit board whose surface is treated with Ni/Au, having an interconnection pattern of copper foil, a plated layer of Ni disposed on a surface of the copper foil, and a plated layer of Au disposed on a surface of the plated layer of Ni. The plated layer of Ni on the surface of copper foil serves as a barrier layer which prevents a Cu - Zn reaction layer, which would otherwise tend to reduce the bonding strength, from being produced in the soldered joints, when electronic parts are mounted on the printed circuit board using the Sn - Zn solder.

## Description

### BACKGROUND OF THE INVENTION

### 1. Field of the Invention:

The present invention relates to a method of mounting various electronic parts on a printed circuit board by soldering.

### 2. Description of the Related Art:

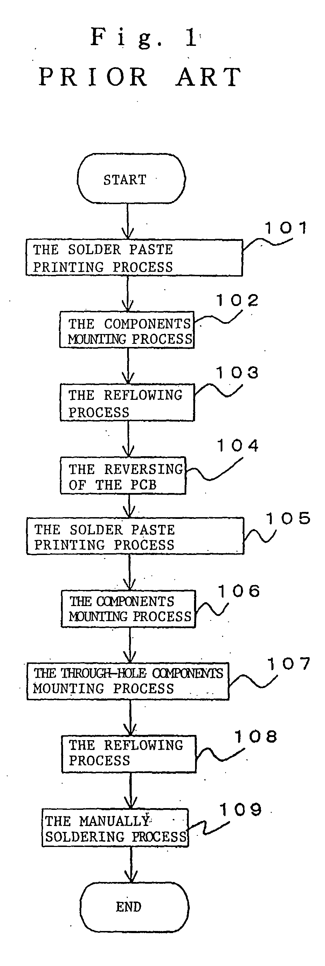

It has heretofore been the customary practice to use soldering to mount electronic parts on a printed circuit board (hereinafter referred to as "PCB"). One example of a process of mounting electronic parts on a PCB by soldering will be described below with reference to Fig. 1 of the accompanying drawings. In the example, electronic parts are soldered to both surfaces of a doublesided PCB by reflow soldering.

In step 101, a solder paste is printed on lands on a surface of a PCB using a metal mask having holes which are defined complementarily to the lands. In step 102, surface-mount components including chip parts, QFPs (Quad Flat Packages), SOPs (Small Outline Packages), etc. are placed on the printed solder paste. Then, in step 103, the PCB with the surface-mount components placed thereon is passed through a high-temperature reflow furnace to melt the solder paste, thus soldering the electrodes of the surface-mount components to the copper foil on the PCB. After the surface-mount components have thus been mounted on one surface of the PCB, the PCB is inverted in step 104, facing the other surface of the PCB upwardly.

In steps 105, 106, a solder paste is applied to and surface-mount components are placed on the other surface of the PCB in the same manner as with steps 101, 102. Thereafter, components having leads are inserted into through holes in the PCB in step 107. The PCB is then passed through the reflow furnace to melt the solder paste, thus soldering the electrodes of the surface-mount components to the copper foil on the PCB in step 108 in the same manner as with step 103.

Finally, any components which cannot withstand the high temperature in the reflow furnace are manually soldered to the PCB in step 109, thus completing the mounting of necessary electronic parts on the PCB.

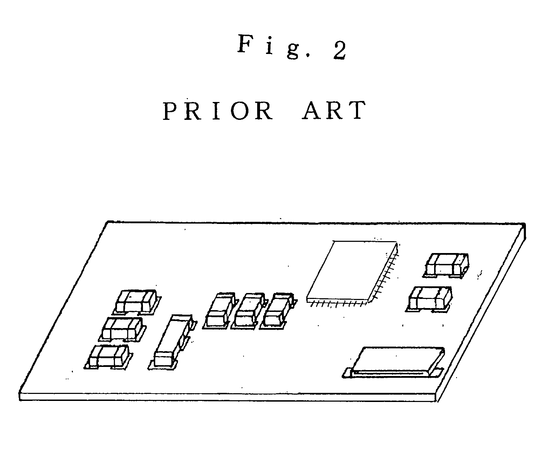

Electronic parts are soldered to a PCB according to the above process, thereby producing a surface-mounted structural assembly as shown in Fig. 2 of the accompanying drawings.

In the conventional process of mounting electronic parts on a PCB, there has generally been used an Sn - Pb solder as the solder paste. However, since the Sn.- Pb solder contains Pb that is a toxic heavy metal, it tends to adversely affect the environment if electronic devices including those PCBs are not properly processed after use. For this reason, there has recently been a demand for the use of Pb-free solder materials on PCBs to prevent environmental pollution.

Sn - Ag solder has widely been known as Pb-free solder. Since the properties of Ag are stable, the Sn-Ag solder is as reliable as the Sn - Pb solder when used to mount electronic parts on PCBs. One problem of the Sn - Ag solder is that the melting point of the Sn - Ag solder is about 220°C that is higher than the melting point of the Sn - Pb solder which is about 183°C. Therefore, it is difficult to directly use surface-mounting facilities and processes that have used the Sn - Pb solder to solder electronic parts with the Sn - Ag solder. Specifically, because general electronic parts have a heat resistance temperature of about 230°C, if the Sn - Ag solder is melted in the reflow furnace to solder the electronic parts, then the temperature of the electronic parts may possibly reach 240°C or higher. Consequently, if electronic parts are to be mounted on PCBs with the Sn - Ag solder, then it is necessary to increase the heat resistance temperature of those electronic parts.

Another type of Pb-free solder is Sn - Zn solder. Since the Sn - Zn solder has a melting point of about 197°C, the conventional surface-mounting facilities and electronic parts can directly be used if the Sn - Zn solder is applied to solder the electronic parts.

However, the Sn - Zn solder is disadvantageous as compared with the Sn - Pb solder in that Zn is easily oxidizable and makes wetting poor. If electronic parts are mounted on PCBs with the Sn - Zn solder using the conventional surface-mounting facilities and processes, the Sn - Zn solder is not as reliable as the Sn - Pb solder.

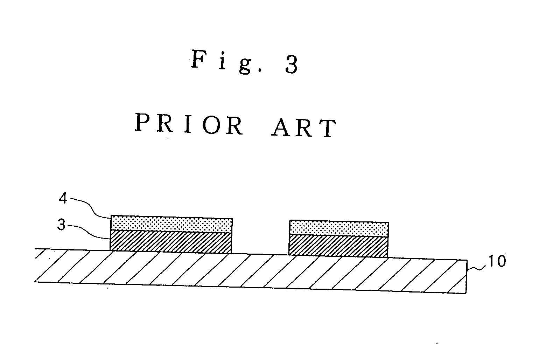

According to the conventional process of mounting electronic parts on PCBs, the PCBs have been prefluxed with a flux applied to the surface of copper foil providing interconnection patterns. The surface of copper foil is prefluxed for the reason that if the surface of copper foil were exposed to the atmosphere, then it would be easily oxidized and have poor wettability with the solder. Fig. 3 of the accompanying drawings shows in cross section a prefluxed PCB. As shown in Fig. 3, the PCB has base 10, copper foil 3 disposed on a surface thereof, and flux layer 4 deposited on copper foil 3. An interconnection pattern on the PCB is covered with an insulating resist layer, and lands are provided by removing the resist layer from portions of the interconnection pattern. The resist layer is omitted from illustration in Fig. 3 and other figures.

While there is another process of preventing the surface of copper foil from being oxidized other than the prefluxing process, the prefluxing process is widely used in the art as it can reduce the cost of PCBs.

Electronic parts can be mounted highly reliably on refluxed PCBs using the Sb - Pb solder. If electronic parts are soldered to a PCB with the surface of copper foil being prefluxed, using the Sn - Zn solder, then the Cu of the copper oil and the Zn of the Sn - Zn solder react with each other, forming a Cu - Zn reaction layer in the soldered joints. The Cu - Zn reaction layer tends to reduce the bonding strength because it becomes brittle at a high temperature of about 150°C.

### SUMMARY OF THE INVENTION

It is therefore an object of the present invention to provide a method of mounting electronic parts on a PCB with Sn - Zn solder without a reduction in the bonding strength.

To achieve the above object, a method of mounting electronic parts on a printed circuit board with Pb-free solder in accordance with the present invention uses a printed circuit board whose surface is treated with Ni/Au, having an interconnection pattern of copper foil, a plated layer of Ni disposed on a surface of the copper foil, and a plated layer of Au disposed on a surface of the plated layer of Ni.

When electronic parts are mounted on the printed circuit board using Sn - Zn solder, plated layer of Ni on the surface of copper foil serves as a barrier layer to prevent a Cu - Zn reaction layer, which would otherwise tend to reduce the bonding strength, from being produced in the soldered joints. Therefore, the bonding strength is not lowered when electronic parts are mounted on the printed circuit board using the Sn - Zn solder.

The above and other objects, features, and advantages of the present invention will become apparent from the following description with reference to the accompanying drawings which illustrate an example of the present invention.

### BRIEF DESCRIPTION OF THE DRAWINGS

Fig. 1 is a flowchart of a process of mounting electronic parts on a PCB with solder;
Fig. 2 is a perspective view of a surface-mounted structural assembly produced by mounting electronic parts on a PCB with solder;
Fig. 3 is a cross-sectional view of a prefluxed PCB; and
Fig. 4 is a cross-sectional view of a PCB treated with Ni/Au, which is used in a method of mounting electronic parts according to the present invention.

### DETAILED DESCRIPTION OF THE PREFERRED EMBODIMENT

In a method of mounting electronic parts according to the present invention, a printed circuit board (PCB) whose surface is treated with Ni/Au is used as a printed circuit board for mounting electronic parts thereon.

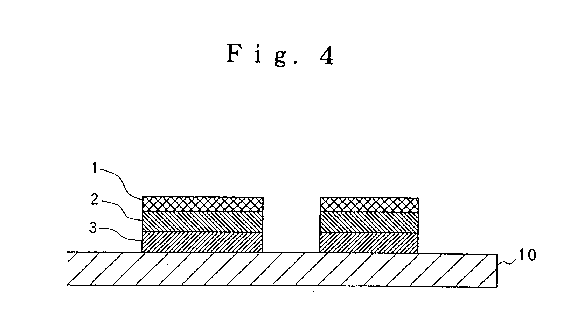

Fig. 4 shows in cross section a PCB whose surface is treated with Ni/Au, which is used in the method of mounting electronic parts according to the present invention. Those parts shown in Fig. 4 which are identical to those shown in Fig. 3 are denoted by identical reference numerals, and will not be described in detail below.

As shown in Fig. 4, the PCB whose surface is treated with Ni/Au comprises base 10, copper foil 3 disposed on a surface of base 10, plated layer 2 of Ni disposed on the surface of copper foil 3, and plated layer 1 of Au disposed on the surface of plated layer 2 of Ni. Generally, plated layer 2 of Ni has a thickness ranging from 3 to 6 µm, and plated layer 1 of Au has a thickness ranging from 0.03 to 0.08 µm.

Plated layer 1 of Au is disposed on the surface of plated layer 2 of Ni because if plated layer 2 of Ni were exposed to the atmosphere, then it would be easily oxidized and have poor wettability with the solder.

When electronic parts are mounted on the PCB shown in Fig. 4 using the Sn - Zn solder, plated layer 2 of Ni on the surface of copper foil 3 serves as a barrier layer to prevent a Cu - Zn reaction layer, which would otherwise tend to reduce the bonding strength, from being produced in the soldered joints. Therefore, the bonding strength is not lowered when electronic parts are mounted on the PCB using the Sn - Zn solder.

In the illustrated embodiment, plated layer 1 of Au is used as a layer for preventing plated layer 2 of Ni from being oxidized. However, the surface of the PCB may be treated with another metal layer insofar as it is capable of protecting plated layer 2 of Ni from the atmosphere against oxidization and providing a desired level of wettability with the solder.

While a preferred embodiment of the present invention has been described using specific terms, such description is for illustrative purposes only, and it is to be understood that changes and variations may be made without departing from the spirit or scope of the following claims.

In summary, the invention can be described as follows: There is disclosed a method of mounting electronic parts with Sn - Zn solder which is Pb-free solder without a reduction in the bonding strength. A printed circuit board for mounting electronic parts with Pb-free solder comprises a printed circuit board whose surface is treated with Ni/Au, having an interconnection pattern of copper foil, a plated layer of Ni disposed on a surface of the copper, foil, and a plated layer of Au disposed on a surface of the plated layer of Ni. The plated layer of Ni on the surface of copper foil serves as a barrier layer which prevents a Cu - Zn reaction layer, which would otherwise tend to reduce the bonding strength, from being produced in the soldered joints, when electronic parts are mounted on the printed circuit board using the Sn - Zn solder.

## Claims

1. A method of mounting electronic parts on a printed circuit board, comprising the steps of:
selecting a printed circuit board whose surface is treated with Ni/Au, having an interconnection pattern of copper foil, a plated layer of Ni disposed on a surface of the copper foil, and a plated layer of Au disposed on a surface of said plated layer of Ni; and
mounting electronic parts on said printed circuit board with Pb-free solder.

2. A method according to claim 1, wherein said Pb-free solder comprises Sn - Zn solder.

3. A printed circuit board whose surface is treated with Ni/Au, having an interconnection pattern of copper foil, a plated layer of Ni disposed on a surface of the copper foil, and a plated layer of Au disposed on a surface of said plated layer of Ni.

4. A surface-mounted structural assembly comprising:
a printed circuit board whose surface is treated with Ni/Au, having an interconnection pattern of copper foil, a plated layer of Ni disposed on a surface of the copper foil, and a plated layer of Au disposed on a surface of said plated layer of Ni; and
electronic parts mounted on said printed circuit board with Pb-free solder.

5. A surface-mounted structural assembly according to claim 4, wherein said Pb-free solder comprises Sn - Zn solder.
